# EUROPÄISCHE PATENTSCHRIFT

(11) **EP 1 163 825 B1**
(45) Veröffentlichungstag und Bekanntmachung des Hinweises auf die Patenterteilung: **05.11.2003**
(21) Anmeldenummer: 00910749.1
(22) Anmeldetag: 01.03.2000
(51) Int. Cl.: H05K 1/02, H05K 3/00, H05K 3/34, H05K 7/20

(54) **VERFAHREN ZUR HERSTELLUNG VON SCHALTUNGSANORDNUNGEN**
METHOD FOR PRODUCING CIRCUIT ARRANGEMENTS
PROCEDE DE PRODUCTION D'ENSEMBLES CIRCUITS

(30) Priorität: 04.03.1999 DE 19909505
(43) Veröffentlichungstag der Anmeldung: 19.12.2001
(73) Patentinhaber: Conti Temic microelectronic GmbH, 90411 Nürnberg (DE)
(72) Erfinder: HEINZ, Helmut, D-91522 Ansbach (DE); SCHUCH, Bernhard, D-91616 Neusitz (DE)
(86) Internationale Anmeldenummer: EP0001770
(87) Internationale Veröffentlichungsnummer: WO00052974

(56) Entgegenhaltungen:
- WO-A-86/06243
- DE-A- 19 842 590
- GB-A- 2 224 961
- GB-A- 2 304 999
- PATENT ABSTRACTS OF JAPAN vol. 1995, no. 11, 26. Dezember 1995 (1995-12-26) & JP 07 221447 A (TANAKA KIKINZOKU KOGYO KK), 18. August 1995 (1995-08-18)
- PATENT ABSTRACTS OF JAPAN vol. 15, no. 383 (E-1116), 27. September 1991 (1991-09-27) & JP 03 152993 A (MATSUSHITA ELECTRIC IND CO), 28. Juni 1991 (1991-06-28)
- PATENT ABSTRACTS OF JAPAN vol. 1999, no. 1, 29. Januar 1999 (1999-01-29) & JP 10 270590 A (HITACHI CHEM CO), 9. Oktober 1998 (1998-10-09)
- PATENT ABSTRACTS OF JAPAN vol. 1999, no. 3, 31. März 1999 (1999-03-31) & JP 10 326847 A (MATSUSHITA ELECTRIC WORKS), 8. Dezember 1998 (1998-12-08)

## Beschreibung

In vielen Anwendungsbereichen der Elektrotechnik werden Schaltungsanordnungen mit Bauteilen eingesetzt, bei deren Betrieb eine hohe Verlustleistung auftritt, insbesondere bei Schaltungsanordnungen mit Leistungsbauteilen, wie bsp. bei Leistungsmodulen zur Ansteuerung von Baugruppen. Die Bauteile der Schaltungsanordnung werden auf einen geeigneten Trägerkörper aufgebracht; bsp. werden in der Kfz-Elektronik oftmals oberflächenmontierbare Leistungsbauteile verwendet, die mit ihrer rückseitigen Anschlußfläche auf einer Leiterplatte als Trägerkörper aufliegen. Um eine ausreichende Wärmeabfuhr der Verlustleistung der Bauteile zu gewährleisten (insbesondere der Verlustleistung der Leistungsbauteile) können einerseits zur Unterstützung des vertikalen Wärmetransports in den Trägerkörper thermische Durchkontaktierungen (sog. thermische vias) eingebracht werden, d.h. Durchkontaktierungen von der Oberseite zur Unterseite des Trägerkörpers; hierzu werden in der Regel direkt unter der rückseitigen Anschlußfläche (der Auflagefläche) der Bauteile (insbesondere der Leistungsbauteile) Durchführungen in den Trägerkörper eingebracht, die ganzflächig und durchgängig metallisiert werden (bsp. mittels einer Kupferbeschichtung). Andererseits kann zur externen Wärmeabfuhr der Trägerkörper auf einen metallischen Kühlkörper (bsp. eine Aluminiumplatte) aufgebracht werden, der die Verlustleistung an ein Kühlsystem weitergeben kann und der mittels einer elektrischen Isolationsschicht (bsp. mittels einer Isolationsfolie) vom Trägerkörper separiert ist.
Nach dem Aufbringen der Bauteile auf die Oberseite der Trägerplatte (die Bestükkungsseite) werden diese in einem Lötprozeß mit Anschlußflächen (Pads) und/oder Leitbahnen einer metallischen Leitbahnstruktur kontaktiert, wobei Lotpaste auf die Anschlußflächen und die Oberfläche der thermischen vias gedruckt und in einem Reflow-Lötprozeß aufgeschmolzen wird. Hierbei können Lot oder Lotspritzer oder ebenfalls aufgeschmolzene Teile der metallischen Leitbahnstruktur aufgrund von Kapillareffekten durch die thermischen vias hindurch auf die Unterseite des Trägerkörpers gezogen werden und dort die elektrische Isolationsschicht beschädigen (bsp. kann eine auf der Unterseite des Trägerkörpers aufgebrachte Isolationsfolie durchstoßen werden) sowie elektrische Kurzschlüsse zum metallischen Kühlkörper hin oder zu einem den Trägerkörper und die Schaltungsanordnung umschließenden Gehäuse hin verursachen.
In der nicht vorveröffentlichten DE 198 425 90 ist ein Verfahren zur Herstellung von Schaltungsanordnungen beschrieben, bei dem vor dem Lötprozeß, d.h. vor dem Bestücken der Leiterplatte mit Bauteilen, alle in den Trägerkörper eingebrachten thermischen Durchkontaktierungen (thermischen vias) von der der Oberseite (Bestückungsseite) des Trägerkörpers gegenüberliegenden Unterseite (Rückseite) des Trägerkörpers her mittels Siebdruck verschlossen werden. Hierbei wird der Durchmesser der thermischen vias an die jeweils angewandte Siebdrucktechnik angepaßt und so vorgegeben, daß eine ausreichende Bedeckung der thermischen vias innerhalb des Öffnungsvolumens stattfindet (bsp. kann eine bestimmte minimale Befüllung innerhalb der thermischen vias gefordert werden). Außerdem sollte nur eine geringe Bedeckung der an die thermischen vias angrenzenden Randbereiche auf der Unterseite des Trägerkörpers mit Siebdruckmaterial stattfinden, da eine Bedeckung der auf der Unterseite des Trägerkörpers vorgesehenen Anschlußflächen mit Siebdruckmaterial den thermischen Übergang und damit das Abführen der Verlustwärme verschlechtern würde und da für weitere Verfahrensschritte bei der Herstellung der Schaltungsanordnung eine plane Oberfläche der Unterseite des Trägerkörpers wünschenswert wäre. Allerdings ist der Aufwand für den Siebdruckprozeß recht hoch, da enge Toleranzen eingehalten werden müssen, um den Überstand des Siebdruckmaterials so gering wie möglich zu halten.

Die Drucksschrifs GB-A-2 304 999 offenbart ein Verfahren gemäß dem Oberbegriff des Anspruchs 1.

Der Erfindung liegt die Aufgabe zugrunde, ein einfaches Verfahren zur Herstellung von Schaltungsanordnungen mit vorteilhaften Eigenschaften bezüglich der Wärmeabfuhr, der Zuverlässigkeit, der Kosten und des Herstellungsprozesses anzugeben.
Diese Aufgabe wird gemäß der Erfindung durch die Merkmale im Kennzeichen des Patentanspruchs 1 gelöst.
Vorteilhafte Ausgestaltungen der Erfindung sind Bestandteil der weiteren Patentansprüche.

Der Siebdruckprozeß zum Einbringen des Siebdruckmaterials in die thermischen Durchkontaktierungen (thermischen vias) wird nach dem Aufbringen einer ersten, die Grundmetallisierung bildenden Metallisierungsschicht (vorzugsweise Kupfer) auf den Trägerkörper durchgeführt (d.h. vor dem Aufbringen mindestens einer weiteren die Endmetallisierung bildenden Metallisierungsschicht), wobei das Siebdruckmaterial ohne Einhaltung enger Toleranzen über die Öffnungen für die thermischen Durchkontaktierungen auf die Grundmetallisierung gedruckt wird. Nach Druck und Aushärten des Siebdruckmaterials werden die auf der Unterseite des Trägerkörpers überstehenden Reste des Siebdruckmaterials mindestens durch einen mechanischen Reinigungsprozeß abgetragen, wodurch einerseits eine plane und andererseits eine saubere (blanke) Oberfläche geschaffen wird, die eine bessere Verarbeitung bei nachfolgenden Verfahrensschritten ermöglicht, bsp. beim Aufbringen weiterer Metallisierungsschichten für die Endmetallisierung und beim Aufbringen einer zur Verbesserung der Wärmeleitung aufgebrachten Isolationsfolie. Insbesondere wird der mechanische Reinigungsprozeß in Form des maschinellen Bürstschleifens durchgeführt, da dies durch variable Steuerung des Materialabtrags durch die Parameter der Bürstschleifmaschine gut an die aktuellen Gegebenheiten angepaßt werden kann; optional können daneben noch weitere mechanische und/oder chemische Reinigungsprozesse vorgenommen werden. Vorteilhafterweise können hier beim Herstellungsprozeß der Schaltungsanordnung übliche Reinigungsprozesse eingesetzt werden. Nach dem Abtragen des überstehenden Siebdruckmaterials wird auf die gereinigte (blanke) Grundmetallisierung mindestens eine weitere Metallisierungsschicht zur Bildung der Endmetallisierung aufgebracht (bsp. wird auf die Kupferschicht der Grundmetallisierung Nickel-Gold chemisch abgeschieden). Anschließend wird auf die plane Oberfläche der Rückseite des Trägerkörpers eine elektrisch isolierende, thermisch leitfähige Folie als Isolationsfolie und Wärmeleitfolie flächenbündig und luftspaltfrei aufgebracht, d.h. die Folie kann mit hoher Montagesicherheit sowie mit direkter und thermisch vollflächiger Anbindung an die thermischen vias aufgebracht werden.
Beim Siebdruckprozeß wird um die thermischen vias herum ein Siebdruckfilm angeordnet und das Siebdruckmaterial zum Erzielen eines bestimmten Füllvolumens in einem mindestens zweistufigen Druckvorgang von der Unterseite des Trägerkörpers her in die Öffnungen der thermischen vias eingedruckt. Für den Siebdruck werden hochviskose, thixotrope (pastöse) vorzugsweise lösungsmittelfreie Materialien verwendet, wobei das Siebdruckmaterial entsprechend dem Material des Trägerkörpers gewählt werden kann; insbesondere wird ein lösungsmittelfreies Feststoffepoxid mit minimaler Volumenreduktion beim Aushärten verwendet. Nach der Prüfung der verschlossenen Öffnungen (bsp. mittels optischer Kontrolle im Gegenlicht oder mittels eines automatisierten Vakuumtests mit der Bestimmung des Fremdluftanteils zur Erkennung evtl. vorhandener Löcher) wird der Trägerkörper getrocknet und das Siebdruckmaterial ausgehärtet. Nach dem Reinigungsprozeß mit der Entfernung überschüssigen Siebdruckmaterials und dem Aufbringen der Metallisierungsschichten für die Endmetallisierung werden die Bauteile der Schaltungsanordnung auf der Oberseite des Trägerkörpers aufgelötet (bsp. mittels eines Reflow-Lötprozesses); infolge des Verschlusses der thermischen vias können Verunreinigungen der Unterseite des Trägerkörpers (insbesondere bedingt durch einen Lotdurchfluß von der Oberseite zur Unterseite des Trägerkörpers durch die thermischen vias hindurch) verhindert werden. Der Wärmetransport von der Oberseite zur Unterseite des Trägerkörpers wird durch das die thermischen vias verschließende Siebdruckmaterial jedoch nicht beeinträchtigt.
Bei Verwendung eines lösungsmittelfreien Siebdruckmaterials, insbesondere eines Feststoffepoxids, kann eine Volumenreduzierung des Siebdruckmaterials bei der Aushärtung vermieden werden, so daß keine Blasen oder Risse im Siebdruckmaterial entstehen können, die die Zuverlässigkeit des Verschlusses der thermischen vias beeinträchtigen würden.

Der Druckvorgang des Siebdruckmaterials in die thermischen vias wird so oft durchgeführt (mindestens jedoch zweimal hintereinander), bis die gewünschte Dicke des Siebdruckmaterials in den thermischen vias (ein bestimmtes Füllvolumen in den thermischen vias) und eine vollständige flächenmäßige Bedeckung der sich auf der Unterseite des Trägerkörpers befindlichen Öffnungen der thermischen vias mit dem Siebdruckmaterial erfolgt ist.

Beim vorgestellten sicheren und einfachen Verfahren zur Herstellung von Schaltungsanordnungen kann vorteilhafterweise bei allen in den Trägerkörper eingebrachten thermischen vias ein Lotdurchfluß durch die thermischen vias hindurch mit geringen Kosten unabhängig von der Ausgestaltung der thermischen vias (unabhängig von der Art der Durchkontaktierung, bsp. des Siebdruckmaterials) auch bei größeren Durchmessern der thermischen vias (bsp. bei einem Durchmesser im Bereich von 0.4 mm bis 1 mm) ohne Beeinträchtigung des thermischen Übergangs vollständig verhindert werden. Gleichzeitig wird die Unterseite des Trägerkörpers für weitere Verfahrensschritte bei der Herstellung der Schaltungsanordnung auf einfache Weise ohne Mehraufwand verbessert, bsp. für das Aufbringen weiterer Metallisierungsschichten oder der Isolationsfolie.

Das Verfahren soll im folgenden anhand eines Ausführungsbeispiels im Zusammenhang mit der Zeichnung beschrieben werden.

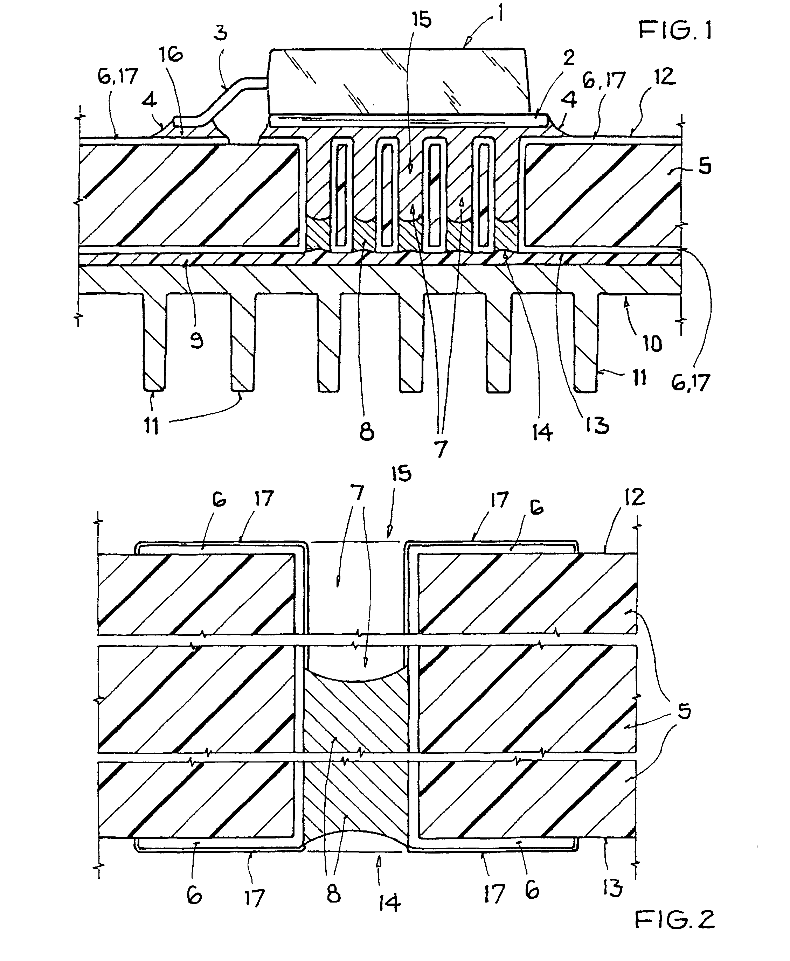

Hierzu ist in der Figur 1 in einer Schnittdarstellung ein Ausschnitt einer auf einem Trägerkörper aufgebrachten Schaltungsanordnung mit einem Leistungsbauteil dargestellt und in der Figur 2 die vergrößerte Darstellung einer thermischen Durchkontaktierung von der Oberseite zur Unterseite des Trägerkörpers.

Die auf der Oberseite 12 eines bsp. als Leiterplatte ausgebildeten Trägerkörpers 5 angeordnete Schaltungsanordnung weist neben weiteren aktiven und passiven Bauteilen auch mindestens ein Leistungsbauteil 1 auf, dessen Anschlußkontakte 3 mit der auf dem Trägerkörper 5 aufgebrachten, bsp. aus mit Nickel-Gold (AuNi) beschichtetem Kupfer bestehenden Leitbahnstruktur über die Anschlußfläche 16 kontaktiert werden sollen. Zum vertikalen Abführen der im Betrieb der Schaltungsanordnung - insbesondere durch die Leistungsbauteile 1 der Schaltungsanordnung-entstehenden Verlustleistung sind im Bereich aller Leistungsbauteile 1 der Schaltungsanordnung bsp. als Bohrungen ausgebildete Durchführungen in die Leiterplatte 5 eingebracht, deren Bewandungen zur Ausbildung thermischer Durchkontaktierungen 7 (thermischer vias) mittels einer Metallisierungsschicht 6 (bsp. Kupfer) vollständig und ganzflächig belegt werden und deren Öffnungen 14, 15 nach dem Aufbringen der Metallisierungsschicht 6 einen Durchmesser von bsp. 0,5 mm aufweisen. Die Leistungsbauteile 1 liegen mit ihrer Kühlfahne 2 auf den auf der Oberseite der Leiterplatte 5 befindlichen Öffnungen 15 der thermischen vias 7 auf, so daß ein effizienter Wärmeübergang von der Oberseite 12 der Leiterplatte 5 zur Unterseite 13 der Leiterplatte 5 ermöglicht wird. Von der Unterseite 13 der Leiterplatte 5 wird die Verlustwärme mittels des mit Kühlrippen 11 versehenen, als Kühlblech ausgebildeten metallischen Kühlkörpers 10 an ein Kühlsystem abgeführt. Zwischen der Unterseite 13 der Leiterplatte 5 und dem Kühlblech 10 ist zur elektrischen Isolation eine thermisch leitfähige, elektrisch isolierende Folie 9 (Isolationsfolie oder Wärmeleitfolie) angeordnet.
Bsp. sollen die Bauteile der Schaltungsanordnung auf die Oberseite 12 der Leiterplatte 5 mittels eines Reflow-Lötprozesses aufgelötet werden. Um einen Durchfluß des Lots 4 von der Oberseite 12 der Leiterplatte 5 zur Unterseite 13 der Leiterplatte 5 beim Löten der Bauteile auf der Oberseite 12 (Reflowseite oder Bestückungsseite) der Leiterplatte 5 zu verhindern, werden die thermischen vias 7 von der Unterseite 13 der Leiterplatte 5 her vor dem Lötprozeß mittels eines Siebdruckprozesses verschlossen.
Nach dem Aufbringen der Grundmetallisierung 6 (bsp. Kupfer mit einer Schichtdicke von 70 µm) auf die Oberfläche der Leiterplatte und in die thermischen vias 7 und deren Strukturierung werden die thermischen vias 7 mittels Siebdruck verschlossen. Hierzu wird auf der Unterseite 13 der Leiterplatte 5 um die bsp. einen Durchmesser von 0.5 mm aufweisenden Öffnungen 14 der thermischen vias 7 herum ein Siebdruckfilm mit einem Durchmesser von bsp. 0.7 mm aufgebracht; der Durchmesser des Siebdruckfilms muß hierbei nicht übermäßig genau stimmen, d.h. er kann großzügige Toleranzen aufweisen. Das Siebdruckmaterial 8, bsp. ein Feststoff-Epoxydmaterial, wird durch einen zweistufigen Druckvorgang (Doppeldruck, zweimaliger naß-in-naß-Druck) derart in die auf der Unterseite 13 der Leiterplatte 5 befindlichen Öffnungen 14 der thermischen vias 7 gedruckt, daß ein bestimmtes Füllvolumen in den thermischen vias 7, d.h. eine minimale Füllhöhe des Siebdruckmaterials 8 in den thermischen vias 7 an der engsten Stelle der thermischen vias 7 erreicht wird (bsp. soll die Füllhöhe mindestens 15 % der Dicke der Leiterplatte 5 betragen) daß das ausgehärtete Siebdruckmaterial 8 keine Defekte (bsp. Einschlüsse, Luftblasen, Poren etc.) aufweist, und daß kein Siebdruckmaterial 8 durch die Durchführungen (Bohrungen) fließt und die Oberseite 12 der Leiterplatte (Bestückungsseite) verunreinigt. Auf der Oberfläche der Unterseite 13 der Leiterplatte 5 entsteht ein bestimmter Schichtauftrag des Siebdruckmaterials 8, bsp. liegt die Schichtdicke des Siebdruckmaterials 8 im Bereich von 30 bis 40 µm.
Nach dem Aushärten des Siebdruckmaterials 8 wird das sich auf der Oberfläche der Unterseite 13 der Leiterplatte 5 befindliche Siebdruckmaterial 8 (insbesondere das im Bereich der Öffnungen 14 und um die Öffnungen 14 herum auf der Unterseite 13 der Leiterplatte 5 überstehende Siebdruckmaterial 8) mittels eines chemischen und mechanischen Reinigungsprozesses entfernt, wobei bsp. das bei der Herstellung von Leiterplatten eingesetzte mechanische Bürstschleifen als mechanischer Reinigungsprozeß verwendet wird. Dieser Reinigungsprozeß wird bsp. 30 s lang durchgeführt, so daß das Siebdruckmaterial 8 vollständig abgetragen wird (bsp. ist noch ein maximaler Überstand des Siebdruckmaterials 8 auf der Oberfläche der Unterseite 13 der Leiterplatte 5 von 100 µm vorhanden); hierdurch wird die Grundmetallisierung 6 für die weiteren Verfahrensschritte vorbereitet, ohne daß das sich in den thermischen vias 7 befindliche Siebdruckmaterial 8 beeinträchtigt wird. Anschließend wird auf der blanken Grundmetallisierung 6 die Endmetallisierung durch Aufbringen weiterer Metallisierungsschichten 17 abgeschieden, bsp. werden alle zugänglichen Bereiche mit blanker Grundmetallisierung 6 (Kupfer) chemisch vernickelt und vergoldet, wobei diese weitere Metallisierungsschicht 17 aus chemischem Nikkel-Gold bsp. eine Schichtdicke von 3 bis 8 µm aufweist. Auf die Unterseite 13 der Leiterplatte 5 wird nun die elektrisch isolierende, thermisch leitfähige Folie 9 bündig und vollflächig aufgebracht, bsp. eine Wärmeleitfolie mit einer Dicke von 150 µm.

## Patentansprüche

1. Verfahren zur Herstellung von Schaltungsanordnungen, deren Bauteile mittels eines Lötprozesses auf die Oberseite (12) eines thermische Durchkontaktierungen (7) aufweisenden Trägerkörpers (5) aufgebracht werden, wobei die thermischen Durchkontaktierungen (7) vor dem Lötprozeß von der Unterseite (13) des Trägerkörpers (5) her mittels eines Siebdruckprozesses mit einem in die thermischen Durchkontaktierungen eingedrückten Siebdruckmaterial (8) verschlossen werden, und wobei auf den Trägerkörper (5) und in die thermischen Durchkontaktierungen (7) eine erste, die Grundmetallisierung bildende Metallisierungsschicht (6) aufgebracht wird,
**dadurch gekennzeichnet,**
**daß** auf die die Grundmetallisierung bildende Metallisierungsschicht (6) das hochviskose Siebdruckmaterial (8) aufgedruckt wird,
**daß** die auf der Unterseite (13) des Trägerkörpers (5) überstehenden Reste des Siebdruckmaterials (8) nach dem Aushärten des Siebdruckmaterials (8) durch mindestens einen mechanischen Reinigungsprozeß und/oder chemischen Reinigungsprozeß abgetragen werden,
- und daß nach dem mindestens einen Reinigungsprozeß mindestens eine weitere, die Endmetallisierung bildende Metallisierungsschicht (17) auf die die Grundmetallisierung bildende Metallisierungsschicht (6) aufgebracht wird.

2. Verfahren nach Anspruch 1, **dadurch gekennzeichnet, daß** als mechanischer Reinigungsprozeß das mechanische Bürstschleifen verwendet wird.

3. Verfahren nach Anspruch 1 oder 2, **dadurch gekennzeichnet, daß** nach dem Aufbringen der die Endmetallisierung bildenden Metallisierungsschicht (17) die Bauteile der Schaltungsanordnung mittels eines Reflow-Lötprozesses auf die Oberseite (12) des Trägerkörpers (5) aufgebracht werden.

4. Verfahren nach einem der Ansprüche 1 bis 3, **dadurch gekennzeichnet, daß** auf die Unterseite (13) des Trägerkörpers (5) eine thermisch leitfähige, elektrisch isolierende Folie (9) aufgebracht wird.

5. Verfahren nach einem der Ansprüche 1 bis 4, **dadurch gekennzeichnet, daß** die thermisch leitfähige, elektrisch isolierende Folie (9) mit einem Kühlkörper (10) verbunden wird.

## Claims

1. Method for producing circuit arrangements, the components of which are applied by means of a soldering process to the top side (12) of a substrate (5) comprising thermal feed-throughs (7), wherein the thermal feed-throughs (7) are sealed before the soldering process from the underside (13) of the substrate (5) by means of a screen printing process with screen printing material (8) which is pressed into the thermal feed-throughs, and wherein a first metallization layer (6), which forms the base metallization, is applied to the substrate (5) and inside the thermal feed-throughs (7), **characterised**
**in that** the highly viscous screen printing material (8) is printed onto the metallization layer (6) forming the base metallization,
**in that** the residual screen printing material (8) remaining on the underside (13) of the substrate (5) is removed following hardening of the screen printing material (8) by at least one mechanical cleaning process and/or chemical cleaning process,
and **in that** at least one further metallization layer (17), which forms the final metallization, is applied to the metallization layer (6) forming the base metallization after the at least one cleaning process.

2. Method according to Claim 1, **characterised in that** mechanical brush abrasion is used as the mechanical cleaning process.

3. Method according to Claim 1 or 2, **characterised in that** the components of the circuit arrangement are applied to the top side (12) of the substrate (5) by means of a reflow soldering process after applying the metallization layer (17) forming the final metallization.

4. Method according to any one of Claims 1 to 3, **characterised in that** a thermally conductive, electrically insulating foil (9) is applied to the underside (13) of the substrate (5).

5. Method according to any one of Claims 1 to 4, **characterised in that** the thermally conductive, electrically insulating foil (9) is joined to a cooling body (10).

## Revendications

1. Procédé de fabrication de dispositifs de circuits, dont les composants sont disposés par soudage sur le côté supérieur (12) d'un support (5) présentant des interconnexions entre couches thermiques (7), les interconnexions entre couches thermiques (7) étant obturées avant le soudage depuis le côté inférieur (13) du support (5) par sérigraphie à l'aide d'un matériau de sérigraphie (8) enfoncé dans les interconnexions entre couches thermiques, et sur le support (5) et dans les interconnexions entre couches thermiques (7) étant disposée une première couche de métallisation (6) formant la métallisation de masse,
**caractérisé en ce que**,
sur la couche de métallisation (6) formant la métallisation de masse est appliqué le matériau de sérigraphie (8) à viscosité élevée,
**en ce que** le reste du matériau de sérigraphie (8) subsistant sur le côté inférieur (13) du support (5) après le durcissement du matériau de sérigraphie est enlevé par au moins un processus de nettoyage mécanique et/ou chimique, et
**en ce qu'**après le au moins un processus de nettoyage au moins une autre couche de métallisation (17) formant la métallisation finale est appliquée sur la couche de métallisation (6) formant la métallisation de masse.

2. Procédé selon la revendication 1, **caractérisé en Ce qu'**en tant que processus de nettoyage mécanique est utilisé un brossage mécanique.

3. Procédé selon la revendication 1 ou 2, **caractérisé en ce qu'**après l'apport de la couche de métallisation (17) formant la métallisation finale, les composants du dispositif de circuit sont déposés sur le côté supérieur (12) du support (5) au moyen d'un processus de soudage par reflux.

4. Procédé selon l'une des revendications 1 à 3, **caractérisé en ce que** sur le côté inférieur (13) du support (5) est disposée une feuille (9) thermiquement conductrice, électriquement isolante.

5. Procédé selon une des revendications 1 à 4, **caractérisé en ce que** la feuille (9) thermiquement conductrice, électriquement isolante est relié à un élément de refroidissement (10).
